# FASCICULE DE BREVET EUROPEEN

(11) **EP 3 413 355 B1**
(45) Date de publication et mention de la délivrance du brevet: **03.03.2021**
(21) Numéro de dépôt: 18176113.1
(22) Date de dépôt: 05.06.2018
(51) Int. Cl.: H01L 31/042

(54) **PANNEAU SOLAIRE COMPORTANT NOTAMMENT UNE STRUCTURE ET AU MOINS DEUX CELLULES PHOTOVOLTAÏQUES**
SOLARPANEL, DAS INSBESONDERE EINE FOTOVOLTAIKSTRUKTUR UND MINDESTENS ZWEI FOTOVOLTAIKZELLEN UMFASST
SOLAR PANEL INCLUDING MAINLY A STRUCTURE AND AT LEAST TWO PHOTOVOLTAIC CELLS

(30) Priorité: 08.06.2017 FR 1755121
(43) Date de publication de la demande: 12.12.2018
(73) Titulaire: Centre National d'Etudes Spatiales, 75001 Paris (FR); Office National d'Etudes et de Recherches Aérospatiales, 91120 Palaiseau (FR)
(72) Inventeur: PAYAN, Denis, 31320 MERVILLA (FR); INGUIMBERT, Virginie, 31450 Montesquieu-Lauragais (FR); SIGUIER, Jean-Michel, 31130 Quint-Fonsegrives (FR)
(74) Mandataire: Delorme, Nicolas

(56) Documents cités:
- EP-A1- 1 326 287
- US-B1- 6 188 012
- HOSODA ET AL: "Development of 400 V Solar Array Technology for Low Earth Orbit Plasma Environment", IEEE TRANSACTIONS ON PLASMA SCIENCE, IEEE SERVICE CENTER, PISCATAWAY, NJ, US, vol. 34, no. 5, 1 octobre 2006 (2006-10-01), pages 1986-1996, XP011149430, ISSN: 0093-3813, DOI: 10.1109/TPS.2006.883287
- Anonymous: "ISIS", , 1 January 2016 (2016-01-01), pages 1-2, XP055665593, Retrieved from the Internet: URL:https://www.isispace.nl/wp-content/upl oads/2016/02/ISIS-Solar-Panels-Brochure-v2 R-web.pdf [retrieved on 2020-02-05]
- Anonymous: "Cubesat solar panels complete set - CubeSatShop.com", , 20 August 2016 (2016-08-20), XP055665726, Retrieved from the Internet: URL:https://web.archive.org/web/2016082005 5526/http://www.cubesatshop.com/product/cu besat-solar-panels-complete-set/ [retrieved on 2020-02-06]
- Jussi Hemmo: "Electrical Power Systems for Finnish Nanosatellites", , 15 November 2013 (2013-11-15), XP055665596, Retrieved from the Internet: URL:https://pdfs.semanticscholar.org/fcdd/ 40c00818eff8ffe6effbc17134308826ef2f.pdf [retrieved on 2020-02-05]

## Description

La présente invention concerne un panneau solaire comportant notamment une structure et au moins deux cellules photovoltaïques.

L'invention trouve notamment son application dans le domaine spatial. Ainsi, le panneau solaire selon l'invention est embarqué au bord d'un engin spatial tel qu'un satellite par exemple et constitue une source d'alimentation électrique pour un tel engin.

De manière générale, le satellite comporte un ou plusieurs panneaux solaires, appelés également générateurs solaires, qui sont utilisés pour alimenter au moins une partie de composants électriques du satellite.

Les structures modernes des satellites se reposent sur le concept « tout électrique » consistant à utiliser de la propulsion de type propulseurs électriques embarqués. Il existe alors une nécessité d'augmenter les capacités des générateurs solaires à produire de l'énergie électrique.

Dans ce contexte, les générateurs solaires doivent fournir des tensions pouvant aller jusqu'à plusieurs centaines de volts (typiquement 350 V pour des propulseurs actuels, voire 600 V pour certains moteurs en cours d'étude).

Il est connu par ailleurs que les composants électriques des satellites et notamment des conducteurs de courant électrique utilisés dans ces composants, sont particulièrement exposés à des risques de court-circuit ou de rupture (circuit ouvert) en cas d'apparition d'un arc électrique.

En effet, dans un environnement spatial dépourvu d'atmosphère, un phénomène précurseur de type décharge électrostatique, impact de micrométéorite, haute tension, ... est susceptible de générer un plasma local. Celui-ci, en se détendant, rend le milieu conducteur et peut établir un court-circuit entre des parties polarisées différentiellement. Un tel court-circuit est connu également sous le nom d'arc électrique.

Le problème d'établissement d'arcs électriques devient particulièrement pertinent au regard des générateurs solaires du fait de la puissance photovoltaïque disponible.

En particulier, des moyens de prévention d'établissement d'arcs électriques utilisés dans les structures actuelles ne sont plus suffisants pour accomplir efficacement ce rôle. Ceci est notamment dû à l'augmentation exigée de la tension du courant électrique fourni par ces générateurs.

Ainsi, il a été aperçu que lorsque la tension électrique générée par ces générateurs solaires devient importante, des arcs électriques apparaissent de manière temporaire, quasi-permanente ou permanente entre différents conducteurs de ces générateurs.

On conçoit alors que ces arcs peuvent endommager considérablement les panneaux solaires et engendrer des pertes de la puissance photovoltaïque disponible de manière partielle (dégradation d'une cellule, d'une rangée ou d'une section entière), voire totale (dégradation d'un panneau complet ou de toute l'aile du générateur solaire) Le document EP 1 326 287 A1 divulgue un dispositif permettant de réduire les risques de décharges électrostatiques primaires et secondaires survenant en particulier sur les générateurs solaires de véhicules spatiaux. Un dispositif concentrateur d'énergie solaire pour véhicule spatial comprend au moins un réflecteur pour la réflexion du rayonnement solaire sur au moins une cellule photovoltaïque.

La présente invention a pour but de proposer un panneau solaire dans lequel le risque d'établissement d'un arc électrique est considérablement diminué.

À cet effet, l'invention a pour objet un panneau solaire comportant une structure en contact avec un milieu ambiant ; au moins deux cellules photovoltaïques, chaque cellule définissant une face latérale de contact et comportant un élément de base, une grille de conducteurs électriques et un élément protecteur en matériau transparent, la grille étant disposée entre l'élément protecteur et l'élément de base et comportant au moins un fil conducteur longeant la face latérale de contact de la cellule ; les deux cellules étant disposées sur la structure de sorte qu'au moins une partie de chacune des faces latérales de contact soit disposée en regard de l'autre partie et de sorte que les éléments protecteurs de ces cellules forment une surface de panneau ; et le panneau solaire étant caractérisé en ce que les cellules sont disposées de sorte que le plus court chemin passant par le milieu ambiant entre les parties en regard des faces latérales des deux cellules soit égal à au moins environ 20 mm Le panneau comporte en outre une barrière en matériau diélectrique disposée sur la structure entre les faces latérales de contact des deux cellules photovoltaïques, s'étendant suivant les parties en regard de ces faces et faisant saillie par rapport à la surface de panneau, le plus court chemin entre les parties en regard des faces latérales de contact étant calculé par contournement de la barrière. La barrière est disposée entre chaque couple des cellules photovoltaïques entre lesquelles la tension est supérieure à 30V.

Suivant d'autres aspects avantageux de l'invention, le panneau comprend une ou plusieurs des caractéristiques suivantes, prise(s) isolément ou suivant toutes les combinaisons techniquement possibles :
- il est conçu pour fonctionner dans un milieu dans lequel la direction perpendiculaire à la surface de panneau s'écarte d'une direction d'éclairage d'un angle d'écartement maximal inférieur à 90°, la direction d'éclairage étant définie par une droite passant par le centre d'une source d'éclairage et d'un point prédéterminé du panneau ;
- la barrière et/ou les cellules sont disposées de sorte que l'ombre générée par la barrière lorsque la direction perpendiculaire à la surface de panneau s'écarte de la direction d'éclairage de l'angle d'écartement maximal, se trouve sensiblement à l'extérieur de chacune des deux cellules ;
- il est embarqué dans un engin spatial ;
- la barrière fait saillie par rapport à la surface de panneau d'au moins environ 10mm;
- les parties en regard des deux cellules sont écartées d'au moins environ 9 mm ;
- la section transversale de la barrière forme un triangle isocèle dont la base est adjacente à la structure, l'angle en regard de la base étant deux fois supérieur à l'angle d'écartement maximal ;
- la structure a une forme allongée suivant un axe longitudinal perpendiculaire à un axe transversal ;
- la grille de chaque cellule comporte une pluralité de fils conducteurs s'étendant suivant l'axe longitudinal ;
- la grille de chaque cellule se présente sous la forme d'un peigne dont les dents sont formées des fils conducteurs s'étendant suivant l'axe longitudinal ;
- il est embarqué dans un engin spatial tournant en suivant une orbite ;
- l'axe longitudinal est perpendiculaire au plan comprenant l'orbite ;
- la barrière est faite d'un matériau flexible, la barrière étant adaptée pour être pliée dans l'espace délimité par les deux faces latérales de contact sans faire saillie par rapport à la surface de panneau ;
- la barrière est faite d'un polymère de polyimide ;
- la barrière est un concentrateur

Ces caractéristiques et avantages de l'invention apparaitront à la lecture de la description qui va suivre, donnée uniquement à titre d'exemple non limitatif, et faite en référence aux dessins annexés, sur lesquels :
- la figure 1 est une vue schématique d'un satellite géostationnaire comportant notamment un panneau solaire selon un premier mode de réalisation de l'invention ;
- la figure 2 est une vue schématique de dessus du panneau solaire de la figure 1 ;
- la figure 3 est une vue schématique en coupe longitudinale d'une partie du panneau solaire de la figure 1 illustrant le premier mode de réalisation de l'invention;
- la figure 4 est une vue analogue à celle de la figure 3 d'un panneau solaire selon un deuxième mode de réalisation de l'invention ;
- la figure 5 est une vue analogue à celle de la figure 3 d'un panneau solaire selon un troisième mode de réalisation de l'invention ; et
- la figure 6 est une vue analogue à celle de la figure 2 d'un panneau solaire selon un quatrième mode de réalisation de l'invention.

Dans la suite de la description, lorsque le terme « environ » est utilisé en relation avec une valeur numérique, il doit être compris que la valeur numérique donnée est approximative avec une marge d'erreur qui est déterminée par l'homme du métier dans chaque cas considéré. À titre d'exemple, cette marge d'erreur est égale à +10% ou -10% de la valeur donnée.

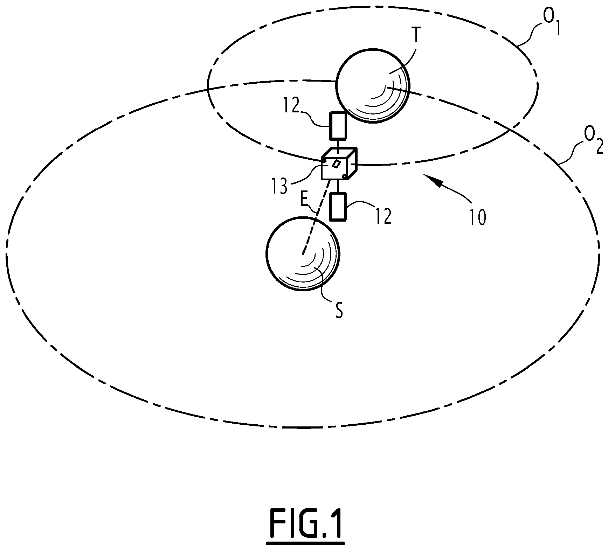

Sur la figure 1, le satellite géostationnaire 10 comporte deux panneaux solaires 12 et 12' selon l'invention disposés de part et d'autre d'un corps 13 du satellite 10 de manière connue en soi.

Le satellite 10 tourne autour de la Terre T en suivant une orbite O₁. La Terre tourne alors autour du Soleil S en suivant une orbite O₂. La droite E passant par le centre du Soleil S et un point fixe du panneau 12 et orientée vers le satellite 10 sera dénotée par la suite par le terme « direction d'éclairage E ».

Les panneaux solaires 12, 12' sont aptes à produire un courant électrique délivrant la puissance de plusieurs kilowatts. La tension de ce courant s'étend par exemple de 28 V jusqu'à 160V, voire jusqu'à 350 V ou plus.

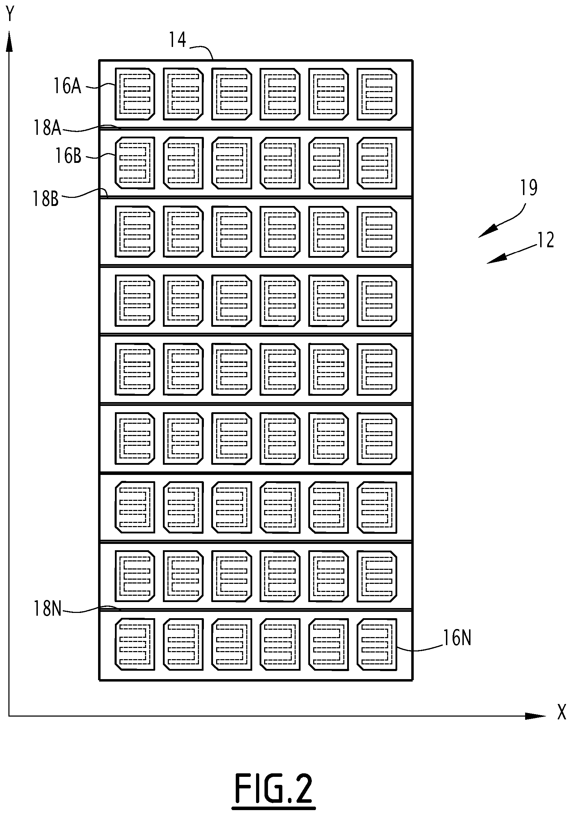

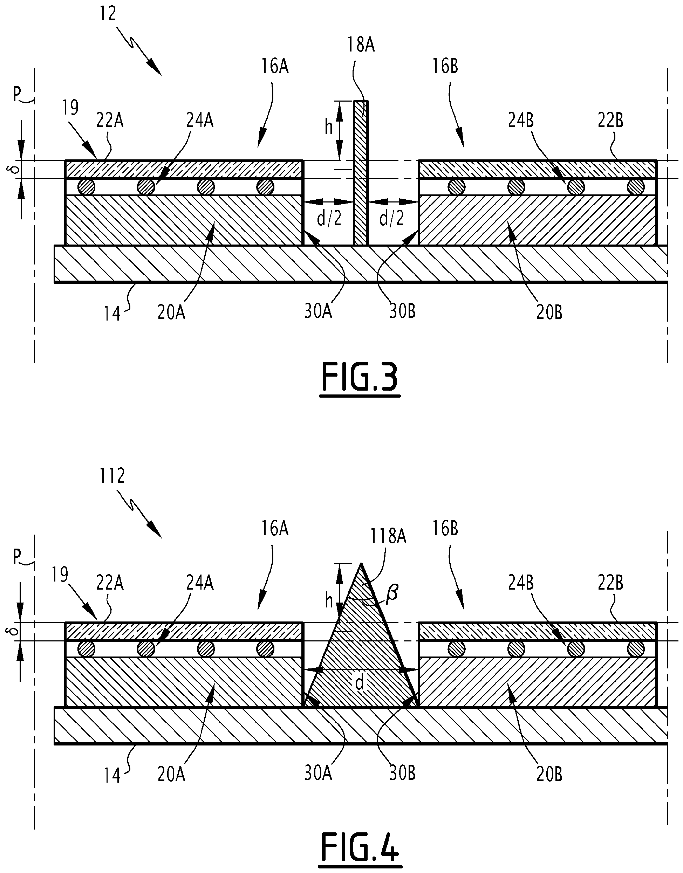

Les panneaux solaires 12, 12' sont sensiblement identiques entre eux. Ainsi, par la suite, seul le panneau solaire 12 sera expliqué en détail en référence notamment aux figures 2 et 3.

Comme cela est illustré sur la figure 2, le panneau solaire 12 a par exemple une forme allongée suivant un axe longitudinal Y perpendiculaire à un axe transversal X. Cette forme est par exemple sensiblement rectangulaire. Dans ce cas, l'axe longitudinal Y s'étend suivant la longueur du rectangle et l'axe transversal X s'étend suivant la largeur de ce rectangle.

Le satellite 10 tourne autour de la Terre T en suivant l'orbite O₁ par exemple de sorte que l'axe longitudinal Y soit perpendiculaire au plan comprenant cette orbite O₁. Dans ce cas, l'axe longitudinal Y est dit axe Nord-Sud.

Le panneau solaire 12 comprend une structure 14, une pluralité de cellules photovoltaïques 16A à 16N aptes à générer un courant électrique et disposées sur la structure 14 en formant des rangées suivant l'axe transversal X,, et une pluralité de barrières diélectriques 18A à 18N disposées entre les rangées des cellules 16A à 16N et s'étendant suivant l'axe transversal X comme ceci sera expliqué par la suite. Par ailleurs, les premières et les dernières cellules de chaque rangée sont appelées par la suite cellules d'extrémité.

La structure 14 est adaptée pour être fixée au corps 13 du satellite 10 et possède des moyens de câblage nécessaires pour conduire un courant électrique entre les cellules 16A à 16N et vers le corps 13 du satellite 10.

Chaque cellule 16A à 16N est apte à produire par exemple un courant électrique de l'ordre de 0,5A, ou de 0,8A, ou même de 1,6 A en fonction de la taille unitaire des cellules solaires, toujours plus grande.

Dans l'exemple de la figure 2, les cellules 16A à 16N sont disposées sur la structure 14 en neuf rangées, chaque rangée étant composée de six cellules et s'étendant suivant l'axe transversal X. Sur la figure 2, seules les premières cellules 16A et 16B des deux premières rangées, la dernière cellule 16N de la dernière rangée, les barrières 18A, 18B séparant les trois premières rangées entre elles et la barrière 18N séparant la dernière rangée de l'avant-dernière rangée, portent des références.

Les cellules 16A à 16N forment une surface de panneau 19 visible sur la figure 3.

La surface de panneau 19 définit une direction P perpendiculaire à cette surface. La direction perpendiculaire P s'écarte de la direction d'éclairage E selon un angle d'écartement α. Lors de différentes phases de la rotation du satellite 10, l'angle d'écartement α varie de 0° jusqu'à la valeur d'un angle d'écartement maximal αₘₐₓ.

L'angle d'écartement maximal αₘₐₓ est égal par exemple à environ 23,45°. Une telle valeur de l'angle d'écartement a pour but d'éviter les ombres portées sur la surface de panneau 19.

Les cellules 16A à 16N sont sensiblement identiques entre elles. Par ailleurs, les barrières 18A à 18N séparant les rangées des cellules sont également sensiblement identiques entre elles.

En particulier, en vue de dessus (la vue de la figure 2), chaque cellule 16A à 16N a une forme hexagonale avec deux angles droits adjacents à un même côté, dit côté long, et quatre autres angles supérieur à 90°, deux de ces angles étant adjacents à un côté parallèle au côté long, dit côté court. La forme est symétrique par rapport à un axe perpendiculaire au côté court et au côté long.

Autrement dit, en vue de dessus, chaque cellule 16A à 16N se présente sous la forme d'un rectangle avec deux angles abattus de manière symétrique.

Dans une même rangée, les cellules 16A à 16N sont disposées de manière classique, c'est-à-dire de sorte que leur côté long (ou le côté court) soit perpendiculaire à l'axe transversal X.

De plus, dans une même rangée, les cellules 16A à 16N sont connectées entres elles par les moyens de câblage s'étendant parallèlement à l'axe transversal X et classiquement appelés interconnecteurs (non-représentés sur la figure 2).

Finalement, comme il est connu en soi, entre des cellules voisines d'une même rangée, la tension est peu différente et est comprise par exemple entre 0,5V et 2,5V en fonction de la technologie des cellules.

Entre chaque couple de rangées différentes, les moyens de câblage raccordent uniquement deux cellules voisines, par exemple les cellules d'extrémité se trouvant sur le même côté du panneau 12.

Ainsi, dans l'exemple de la figure 2, les moyens de câblage raccordent les cellules d'une même rangée transversalement et les cellules de rangées différentes longitudinalement.

À titre d'exemple, sur la figure 2, les dernières cellules des deux premières rangées sont connectées par les moyens de câblage. Comme dans le cas précédent, la tension entre ces cellules voisines est comprise par exemple entre 0,5V et 2,5V en fonction de la technologie des cellules.

Dans l'exemple de réalisation de la figure 2, chaque barrière 18A à 18N s'étend suivant l'axe transversal X sensiblement entre les cellules d'extrémité d'une même rangée, c'est-à-dire tout au long de la rangée correspondante. Dans ce cas, les moyens de câblage entre différentes rangées passent par contournement de la barrière correspondante ou par dessous le panneau comme cela est fait classiquement pour chaque rangée de cellule.

Toutefois, dans le cas général, l'étendue de chaque barrière 18A à 18N le long de la rangée correspondante peut être ajustée en fonction de la disposition des cellules 16A à 16N et des moyens de câblage.

En particulier, lorsque des cellules d'extrémité de deux rangées adjacentes sont connectées par les moyens de câblage, il n'est pas nécessaire d'étendre la barrière 18A à 18N correspondante jusqu'à ces cellules compte tenu du fait que la tension entre ces cellules est relativement faible (entre 0,5V et 2,5V).

De manière générale, selon l'invention, une barrière 18A à 18N est disposée entre chaque couple de cellules 16A à 16N entre lesquelles la tension est supérieure à 30 V.

Une attention particulière sera portée aux endroits où suivant le mode de réalisation, on pourrait avoir une fin de rangée à une tension élevée au voisinage d'une boucle sur une même rangée de cellule, La barrière devra alors protéger les cellules présentant une tension élevée avec une distance suffisante entre les cellules à la fois en hauteur ou rasante. Le câblage de la rangée voisine devra alors contourner ou traverser la barrière. La barrière pourra présenter une encoche pour pouvoir être mise en place après le câblage.

Finalement, lorsque les cellules 16A à 16N sont de formes plus complexes (trapézoïdale, demi hexagonale ou demi octogonale, ou autre), les barrières 18A à 18N ne sont plus droites, mais forment des zigzags. Dans ce cas, les cellules 16 à 16N sont orientées de manière à ce que les barrières correspondantes 18A à 18N génèrent le moins d'ombre possible sur sa plus grande longueur possible.

Par la suite, seules les cellules adjacentes 16A et 16B et la barrière 18A séparant ces cellules 16A, 16B seront expliquées plus en détail en référence notamment à la figure 3 illustrant une partie du panneau solaire 10 en coupe longitudinale.

Comme cela est illustré sur la figure 3, chacune des cellules 16A, 16B, comporte un élément de base 20A, 20B fixé sur la structure 14, un élément protecteur 22A, 22B couvrant l'élément de base 20A, 20B, et une grille de conducteurs électriques 24A, 24B disposée entre l'élément de base 20A, 20B et l'élément protecteur 22A, 22B.

L'élément de base 20A, 20B est connu en soi. Un tel élément comprend notamment une plaque conductrice, une couche inférieure composée d'un semi-conducteur dopé P et couvrant la plaque conductrice, et une couche supérieure composée d'un semi-conducteur dopé *N* et couvrant la couche inférieure.

L'élément protecteur 22A, 22B est fait d'un matériau transparent tel qu'un verre par exemple, et permet de protéger la cellule 16A, 16B contre la dose radiative tout en laissant passer la lumière vers l'élément de base 20A, 20B. Cet élément 22A, 22B est également connu sous le terme anglais « coverglass ».

La grille 24A, 24B comporte une pluralité de fils conducteurs disposés de manière homogène sur toute la surface de l'élément de base 20A.

En particulier, la grille 24A, 24B se présente sous la forme d'un peigne (visible sur la figure 2) avec les fils conducteurs s'étendant suivant l'axe transversal X. De manière connue en soi, une telle structure laisse passer la lumière vers l'élément de base 20A, 20B.

Chacune des deux cellules 16A, 16B définit une face latérale de contact 30A, 30B. Les faces latérales de contact 30A, 30B sont disposées l'une en regard de l'autre. Ainsi, un fil conducteur de chacune des grilles 24A, 24B longe la face latérale de contact 30A, 30B correspondante.

Les faces latérales de contact 30A, 30B sont écartées l'une de l'autre d'une distance d.

La barrière 18A est disposée entre les faces latérales de contact 30A, 30B de manière symétrique.

La barrière 18A fait saillie par rapport à la surface de panneau 19. Sur la figure 3, la référence h correspond à la longueur de la partie saillante s'étendant selon la direction perpendiculaire P, de la barrière 18A par rapport à la surface de panneau 19, et la référence δ correspond à l'épaisseur des éléments protecteurs 22A, 22B. Ainsi, la barrière 18A fait saillie par rapport aux extrémités des grilles 24A, 24B en contact avec les éléments protecteurs 22A, 22B d'une valeur h + δ. Cette valeur h + δ est supérieure à environ 10 mm.

Ainsi, dans cet exemple de réalisation, le plus court chemin entre les gilles 24A et 24B et notamment entre les fils longeant les faces latérales de contact 30A, 30B, par contournement de la barrière 18A, est égal à au moins environ 20 mm.

La barrière 18A est une plaque fine fixée sur la structure 14 et faite par exemple en verre ou encore d'un polymère de polyimide, notamment sous la forme du matériau connu sous le nom de Kapton® ou UPILEX®. Toutefois, plus généralement, la barrière 18A peut être faite en tout matériau diélectrique. Avantageusement on peut choisir des diélectriques résistant bien à la température (Polyimide Kapton™, Téflon ™, Covergalss tous types, ...)

Avantageusement, le matériau de la barrière 18A est flexible. Dans ce cas, la barrière 18A est adaptée pour être pliée dans l'espace délimité entre les deux faces latérales de contact 30A et 30B sans faire saillie par rapport à la surface de panneau 19. Une telle configuration de la barrière 18A permet par exemple de la garder pliée lors du lancement du satellite et de sa mise à poste, c'est-à-dire, avant déploiement des panneaux solaires 12, 12'.

Selon le premier mode de réalisation de l'invention, les cellules 16A et 16B sont disposées de sorte que l'ombre générée par la barrière 18A lorsque la direction perpendiculaire P à la surface de panneau 19 s'écarte de la direction d'éclairage E de l'angle d'écartement maximal αₘₐₓ, se trouve sensiblement à l'extérieur de chacune des deux cellules 30A, 30B.

Ainsi, selon ce mode de réalisation, la distance d entre les faces latérales de contact 30A, 30B des cellules 16A, 16B est comprise par exemple entre 6 mm et 12 mm, de préférence entre 8 mm et 10 mm, et avantageusement égale à environ 9 mm.

La barrière 18A est donc écartée de chacune des faces latérales de contact 30A, 30B d'environ 4,5 mm.

On conçoit alors que la présente invention présente un certain nombre d'avantages.

Tout d'abord, il a été démontré que lorsque le plus court chemin entre des composants conducteurs des cellules photovoltaïques adjacentes augmente, le risque d'établissement d'un arc électrique entre ces composants est considérablement diminué.

Ainsi, une barrière diélectrique insérée entre deux faces latérales de contact de cellules et dépassant la surface de panneau, permet de rallonger ce chemin et de diminuer ainsi le risque d'établissement d'un arc électrique.

De plus, en choisissant les dimensions de la partie saillante de cette barrière de manière particulière, il est possible de minimiser le risque d'établissement d'un arc électrique tout en gardant une disposition compacte des cellules sur la structure.

En particulier, il a été démontré que la valeur minimale du chemin le plus court entre des composants conducteurs des cellules photovoltaïques adjacentes doit être d'environ 20 mm. Ceci est le cas lorsque la valeur h + δ est d'environ 10 mm.

Selon le premier mode de réalisation de l'invention, les cellules adjacentes sont écartées l'une de l'autre uniquement pour que la barrière ne génère pas d'ombre portée sur la surface utile des cellules même lorsque la direction d'éclairage E et la direction perpendiculaire P forment l'angle d'écartement maximal αₘₐₓ. Ceci permet alors de garder la même productivité du panneau selon l'invention par rapport à un panneau conventionnel et ceci quelle que soit la position du satellite.

Finalement, la flexibilité des barrières fait de sorte que la présence des barrières sur les panneaux ne requiert pas de changement structurel de ces panneaux. En effet, les panneaux solaires selon l'invention peuvent être pliés l'un sur l'autre lors notamment de la phase de lancement du satellite, sans que les barrières fassent obstacle à ce pliage.

Un panneau solaire 112 selon un deuxième mode de réalisation de l'invention est illustré sur la figure 4.

Le panneau solaire 112 est analogue au panneau solaire 12 décrit précédemment et comporte notamment une structure 14 et des cellules photovoltaïques 16A à 16N sensiblement identiques à celles décrites précédemment.

Le panneau solaire 112 comporte en outre une pluralité de barrières 118A à 118N qui diffèrent des barrières 18A à 18N décrites précédemment uniquement par leur forme dans la section transversale.

Ainsi, comme ceci est illustré sur la figure 4 en relation avec la barrière 118A, chaque barrière 118A à 118N a une forme de triangle isocèle dans sa section transversale.

La longueur de la base de ce triangle est égale à la valeur de la distance d mentionnée précédemment, le triangle faisant saillie par rapport à la surface de panneau 19 de la même valeur h mentionnée précédemment.

L'angle β du triangle en regard de la base est égal à environ deux angles d'écartement maximal αₘₐₓ.

Ainsi, comme dans le cas précédent, les barrières 118A à 118N permettent de minimiser le risque d'établissement d'arc électrique entre chaque paire de cellules adjacente et ne génèrent pas d'ombre portée sur ces cellules.

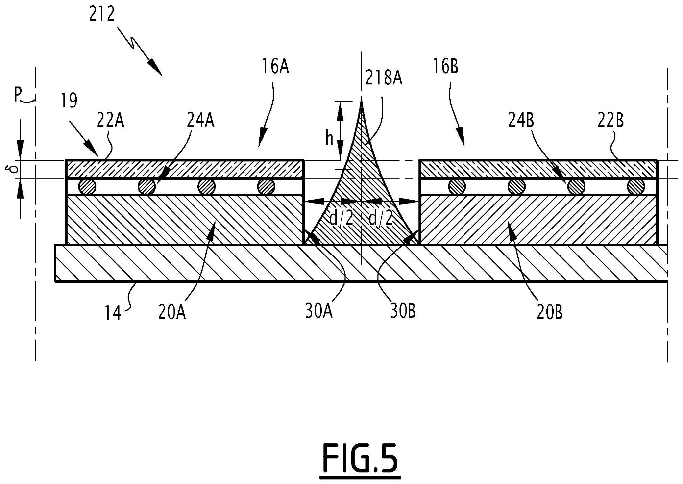

Un panneau solaire 212 selon un troisième mode de réalisation de l'invention est illustré sur la figure 5.

Le panneau solaire 212 est analogue au panneau solaire 112 décrit précédemment et comporte notamment une structure 14 et des cellules photovoltaïques 16A à 16N sensiblement identiques à celles décrites précédemment.

Le panneau solaire 212 comporte en outre une pluralité de barrières 218A à 218N qui diffèrent des barrières 118A à 118N décrites précédemment en ce que chaque barrière 218A à 218N se présente sous la forme d'un concentrateur.

Ainsi, comme ceci est illustré sur la figure 5 en relation avec la barrière 218A, chaque barrière 218A à 218N a une forme de triangle isocèle curviligne dans sa section transversale avec une base rectiligne.

La longueur de la base de ce triangle est égale à la valeur de la distance d mentionnée précédemment, le triangle faisant saillie par rapport à la surface de panneau 19 de la même valeur h mentionnée précédemment.

L'angle β du triangle en regard de la base est égal à environ deux angles d'écartement maximal αₘₐₓ.

La surface des barrières 218A à 218N exposée aux rayons du Soleil S est recouverte d'un matériau réfléchissant. La forme des faces curvilignes des barrières 218A à 218N est adaptée pour réfléchir les rayons vers les cellules correspondantes.

Comme dans les cas précédents, les barrières 218A à 218N permettent de minimiser le risque d'établissement d'arc électrique entre chaque paire de cellules adjacente et ne génèrent pas d'ombre portée sur ces cellules.

De plus, selon ce mode de réalisation, la productivité du panneau solaire 213 se trouve améliorée grâce aux barrières 218A à 218N se présentant sous la forme des concentrateurs.

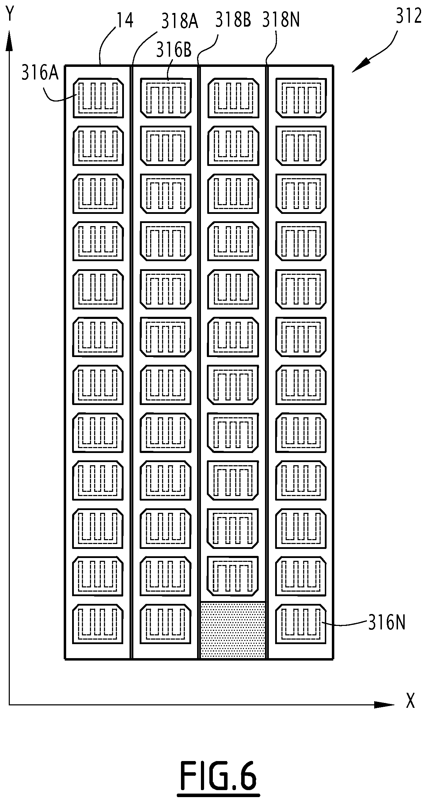

Un panneau solaire 312 selon un quatrième mode de réalisation de l'invention est illustré sur la figure 6.

Le panneau solaire 312 est analogue au panneau solaire 12 décrit précédemment et comporte notamment une structure 14.

Le panneau solaire 312 comporte en outre une pluralité de cellules photovoltaïques 316A à 316N disposées sur la structure 14 en formant des rangées suivant l'axe longitudinal Y et une pluralité de barrières 318A à 318N disposées entre les rangées des cellules 316A à 316N. Comme dans le cas précédent, les premières et les dernières cellules de chaque rangée sont appelées par la suite cellules d'extrémité.

Le panneau solaire 312 diffère des panneaux décrits précédemment uniquement par la disposition des cellules 316A à 316N sur la structure 14.

En particulier, selon ce mode de réalisation, les cellules 316A à 316N sont disposées sur la structure 14 en quatre rangées, chaque rangée étant composée de douze cellules au plus et s'étendant suivant l'axe longitudinal Y. Sur la figure 6, seules les premières cellules 316A et 316B des deux premières rangées et la dernière cellule 316N de la dernière rangée, portent des références.

Par ailleurs, selon ce mode de réalisation, dans une même rangée, les cellules 316A à 316N sont connectées entres elles par les moyens de câblage s'étendant parallèlement à l'axe longitudinal Y.

Comme dans le cas précédent, entre des cellules voisines d'une même rangée, la tension est peu différente et est comprise par exemple entre 0,5V et 2,5V en fonction de la technologie des cellules.

Entre chaque couple de rangées différentes, les moyens de câblage raccordent les cellules correspondantes, et de préférence des cellules d'extrémité, en contournant la barrière 318A à 318N correspondante.

Dans l'exemple de la figure 6, les barrières 318A à 318N s'étendent tout au long des rangées correspondantes. Toutefois, comme dans le cas précédent, l'étendue des barrières 318A à 318N peut être raccourcie dans les endroits où les moyens de câblage raccordent deux cellules des rangées différentes compte tenu d'une tension relativement faible entre ces cellules.

Toutefois, selon l'invention, une barrière 318A à 318N est disposée entre chaque couple de cellules 316A à 316N entre lesquelles la tension est supérieure à 30 V.

Chaque barrière 318A à 318B est analogue à l'une des barrières 18A, 118A ou 218A décrite précédemment.

Comme dans les cas précédents, chaque barrière 318A à 318N fait saillie par rapport à la surface de panneau 19 de la même valeur h mentionnée précédemment, pour minimiser le risque d'établissement d'un arc électrique.

La disposition des barrières 318A à 318N suivant l'axe longitudinal Y constitue un avantage particulier de l'invention selon le quatrième mode de réalisation. En effet, une telle disposition des barrières 318A à 318N par rapport au Soleil S fait de sorte que les barrières 318A à 318N ne génèrent pas d'ombre portée sur les cellules.

Ainsi, la distance d entre les faces latérales de contact de chaque paire des cellules 316A à 316N appartenant aux rangées différentes peut être avantageusement réduite afin de rendre la disposition de ces cellules sur la structure 14 plus compacte.

Selon ce mode de réalisation, cette distance d est par exemple égale à 0,9 +/-0,3 mm.

De plus, contrairement à la disposition des cellules illustrée sur la figure 2, il n'y a plus de besoin d'écarter les cellules suivant l'axe longitudinal Y. Ainsi, les cellules sur la figure 6 sont disposées sur la structure 14 de manière particulièrement compacte, notamment suivant l'axe longitudinal Y et ceci sans modifier les dimensions habituelles d'un panneau solaire sans barrière.

Bien entendu, d'autres modes de réalisation de l'invention sont également possibles.

En particulier, il est possible de combiner au moins certains des modes de réalisation décrits précédemment afin d'obtenir un panneau solaire comportant au moins une barrière minimisant le risque d'établissement d'un arc électrique entre deux cellules adjacentes sans générer une ombre portée sur ces cellules.

La barrière peut être continue ou discontinue lorsque la tension redescend en dessous de 30 V ou pour faciliter un mode de pliage où lorsque le gap entre cellule n'est pas droit du fait de la forme des cellules (trapézoïdale par exemple).

La barrière diélectrique peut être formée d'un matériau à mémoire de forme, pour retrouver la forme voulue après déploiement ou éclairement (par transmission d'énergie).

Par ailleurs, il doit être compris que le panneau solaire selon l'invention peut être embarqué à tout engin mobile autre qu'un satellite ou de manière générale, peut être utilisé indépendamment de tout engin mobile, par exemple dans une configuration fixe sur la surface terrestre.

De préférence, dans tous les modes de réalisation de l'invention, la distance d entre les faces latérales de contact de chaque paire des cellules voisines est inférieure à chaque dimension de ces cellules (largeur, longueur et hauteur), avantageusement est au moins deux fois inférieure à chacune de ces dimensions. Par ailleurs, de préférence, cette distance d est inférieure à 30 mm, avantageusement inférieure à 20 mm et encore plus avantageusement inférieure à 10 mm.

## Revendications

1. Panneau solaire (12 ; 112 ; 212 ; 312) comportant :
- une structure (14) en contact avec un milieu ambiant ;
- au moins deux cellules photovoltaïques (16A, 16B ; 316A, 316B), chaque cellule (16A, 16B ; 316A, 316B) définissant une face latérale de contact (30A, 30B) et comportant un élément de base (20A, 20B), une grille de conducteurs électriques (24A, 24B) et un élément protecteur (22A, 22B) en matériau transparent, la grille (24A, 24B) étant disposée entre l'élément protecteur (22A, 22B) et l'élément de base (20A, 20B) et comportant au moins un fil conducteur longeant la face latérale de contact (30A, 30B) de la cellule (16A, 16B ; 316A, 316B) ;
les deux cellules (16A, 16B ; 316A, 316B) étant disposées sur la structure (14) de sorte qu'au moins une partie de chacune des faces latérales de contact (30A, 30B) soit disposée en regard de l'autre partie et de sorte que les éléments protecteurs (22A, 22B) de ces cellules (16A, 16B ; 316A, 316B) forment une surface de panneau (19) ; les cellules (16A, 16B ; 316A, 316B) étant disposées de sorte que le plus court chemin passant par le milieu ambiant entre les parties en regard des faces latérales de contact (30A, 30B) des deux cellules (16A, 16B ; 316A, 316B) soit égal à au moins environ 20 mm,
le panneau solaire (12; 112; 212; 312) étant **caractérisé en ce qu'**il comporte en outre une barrière (18A ; 118A; 218A ; 318A) en matériau diélectrique disposée sur la structure (14) entre les faces latérales de contact (30A, 30B) des deux cellules photovoltaïques (16A, 16B ; 316A, 316B), s'étendant suivant les parties en regard de ces faces (30A, 30B) et faisant saillie par rapport à la surface de panneau (19), le plus court chemin entre les parties en regard des faces latérales de contact (30A, 30B) étant calculé par contournement de la barrière (18A ; 118A ; 218A ; 318A), la barrière (18A ; 118A ; 218A ; 318A) étant disposée entre chaque couple des cellules photovoltaïques (16A, 16B ; 316A, 316B) entre lesquelles la tension est supérieure à 30V.

2. Panneau (12 ; 112 ; 212 ; 312) selon la revendication 1, **caractérisé :**
- **en ce qu'**il est conçu pour fonctionner dans un milieu dans lequel la direction perpendiculaire (P) à la surface de panneau (19) s'écarte d'une direction d'éclairage (E) d'un angle d'écartement maximal (αmax) inférieur à 90°, la direction d'éclairage (E) étant définie par une droite passant par le centre d'une source d'éclairage (S) et d'un point prédéterminé du panneau ; et
- **en ce que** la barrière (18A ; 118A ; 218A ; 318A) et/ou les cellules (16A, 16B) sont disposées de sorte que l'ombre générée par la barrière (18A ; 118A ; 218A ; 318A) lorsque la direction perpendiculaire (P) à la surface de panneau (19) s'écarte de la direction d'éclairage (E) de l'angle d'écartement maximal (αmax), se trouve sensiblement à l'extérieur de chacune des deux cellules (16A, 16B ; 316A, 316B).

3. Panneau (12 ; 112 ; 212 ; 312) selon la revendication 1 ou 2, **caractérisé en ce qu'**il est embarqué dans un engin spatial (10).

4. Panneau (12 ; 112 ; 212 ; 312) selon l'une quelconque des revendications 1 à 3, **caractérisé en ce que** la barrière (18A ; 118A ; 218A ; 318A) fait saillie par rapport à la surface de panneau (19) d'au moins environ 10mm.

5. Panneau (12 ; 112 ; 212) selon l'une quelconque des revendications 1 à 4, **caractérisé en ce que** les parties en regard des deux cellules sont écartées d'au moins environ 9 mm.

6. Panneau (112 ; 212 ; 312) selon l'une quelconque des revendications 2 à 5, **caractérisé en ce que** la section transversale de la barrière (118A ; 218A ; 318A) forme un triangle isocèle dont la base est adjacente à la structure (14), l'angle en regard de la base étant deux fois supérieur à l'angle d'écartement maximal (amax).

7. Panneau (312) selon l'une quelconque des revendications précédentes, **caractérisé :**
- **en ce que** la structure (14) a une forme allongée suivant un axe longitudinal (Y) perpendiculaire à un axe transversal (X) ; et
- **en ce que** la grille de chaque cellule (316A, 316B) comporte une pluralité de fils conducteurs s'étendant suivant l'axe longitudinal (Y).

8. Panneau (312) selon la revendication 7, **caractérisé en ce que** la grille de chaque cellule (316A, 316B) se présente sous la forme d'un peigne dont les dents sont formées des fils conducteurs s'étendant suivant l'axe longitudinal (Y).

9. Panneau (312) selon la revendication 7 ou 8, **caractérisé :**
- **en ce qu'**il est embarqué dans un engin spatial (10) tournant en suivant une orbite (O1) ; et
- **en ce que** l'axe longitudinal (Y) est perpendiculaire au plan comprenant l'orbite (O1).

10. Panneau (12 ; 112 ; 212 ; 312) selon l'une quelconque des revendications 1 à 9, **caractérisé en ce que** la barrière (18A ; 118A ; 218A ; 318A) est faite d'un matériau flexible, la barrière (18A ; 118A ; 218A ; 318A) étant adaptée pour être pliée dans l'espace délimité par les deux faces latérales de contact (30A, 30B) sans faire saillie par rapport à la surface de panneau (19).

11. Panneau (12 ; 112 ; 212 ; 312) selon l'une quelconque des revendications 1 à 10, **caractérisé en ce que** la barrière (18A ; 118A ; 218A ; 318A) est faite d'un polymère de polyimide.

12. Panneau (212) selon l'une quelconque des revendications 1 à 11, **caractérisé en ce que** la barrière (218A) est un concentrateur.

## Patentansprüche

1. Solarpanel (12; 112; 212; 312), umfassend:
- eine Struktur (14) in Kontakt mit einem umgebenden Medium;
- mindestens zwei Photovoltaikzellen (16A, 16B; 316A, 316B), wobei jede Zelle (16A, 16B; 316A, 316B) eine seitliche Kontaktfläche (30A, 30B) definiert und ein Basiselement (20A, 20B), ein Gitter von elektrischen Leitern (24A, 24B) und ein Schutzelement (22A, 22B) aus transparentem Material umfasst, wobei das Gitter (24A, 24B) zwischen dem Schutzelement (22A, 22B) und dem Basiselement (20A, 20B) angeordnet ist und mindestens einen Leitungsdraht umfasst, der an der seitlichen Kontaktfläche (30A, 30B) der Zelle (16A, 16B; 316A, 316B) entlangläuft;
wobei die zwei Zellen (16A, 16B; 316A, 316B) auf der Struktur (14) so angeordnet sind, dass mindestens ein Teil jeder der seitlichen Kontaktflächen (30A, 30B) gegenüber dem anderen Teil angeordnet ist und so, dass die Schutzelemente (22A, 22B) dieser Zellen (16A, 16B; 316A, 316B) eine Paneloberfläche (19) bilden;
wobei die Zellen (16A, 16B; 316A, 316B) so angeordnet sind, dass der kürzeste Weg, der durch das umgebende Medium zwischen den gegenüberliegenden Teilen der seitlichen Kontaktflächen (30A, 30B) der zwei Zellen (16A, 16B; 316A, 316B) verläuft, mindestens ungefähr 20 mm beträgt,
wobei das Solarpanel (12; 112; 212; 312) **dadurch gekennzeichnet ist, dass** es weiter eine Schranke (18A; 118A; 218A; 318A) aus dielektrischem Material umfasst, die auf der Struktur (14) zwischen den seitlichen Kontaktflächen (30A, 30B) der zwei Photovoltaikzellen (16A, 16B; 316A, 316B) angeordnet ist, sie sich gemäß den gegenüberliegenden Teilen dieser Flächen (30A, 30B) erstreckt und in Bezug auf die Paneloberfläche (19) vorragt, wobei der kürzeste Weg zwischen den gegenüberliegenden Teilen der seitlichen Kontaktflächen (30A, 30B) durch Umgehung der Schranke (18A; 118A; 218A; 318A) berechnet wird, wobei die Schranke (18A; 118A; 218A; 318A) zwischen jedem Paar von Photovoltaikzellen (16A, 16B; 316A, 316B) angeordnet ist, zwischen denen die Spannung höher ist als 30 V.

2. Panel (12; 112; 212; 312) nach Anspruch 1, **dadurch gekennzeichnet:**
- **dass** es ausgelegt ist, um in einem Medium zu funktionieren, in dem die zu der Paneloberfläche (19) senkrechte Richtung (P) von einer Beleuchtungsrichtung (E) um einen maximalen Abweichungswinkel (amax) von weniger als 90° abweicht, wobei die Beleuchtungsrichtung (E) durch eine Gerade definiert wird, die durch die Mitte einer Beleuchtungsquelle (S) und eines vorbestimmten Punkts des Panels verläuft; und
- **dass** die Schranke (18A; 118A; 218A; 318A) und/oder die Zellen (16A, 16B) so angeordnet sind, dass der Schatten, der von der Schranke (18A; 118A; 218A; 318A) erzeugt wird, wenn die zu der Paneloberfläche (19) senkrechte Richtung (P) von der Beleuchtungsrichtung (E) um den maximalen Abweichungswinkel (amax) abweicht, im Wesentlichen außerhalb von jeder der zwei Zellen (16A, 16B; 316A, 316B) liegt.

3. Panel (12; 112; 212; 312) nach Anspruch 1 oder 2, **dadurch gekennzeichnet, dass** es sich an Bord in einem Raumfahrzeug (10) befindet.

4. Panel (12; 112; 212; 312) nach einem der Ansprüche 1 bis 3, **dadurch gekennzeichnet, dass** die Schranke (18A; 118A; 218A; 318A) in Bezug auf die Paneloberfläche (19) um mindestens 10 mm vorragt.

5. Panel (12; 112; 212) nach einem der Ansprüche 1 bis 4, **dadurch gekennzeichnet, dass** die gegenüberliegenden Teile der zwei Zellen um mindestens ungefähr 9 mm beabstandet sind.

6. Panel (112; 212; 312) nach einem der Ansprüche 2 bis 5, **dadurch gekennzeichnet, dass** der Querschnitt der Schranke (118A; 218A; 318A) ein gleichschenkliges Dreieck bildet, dessen Basis an die Struktur (14) angrenzt, wobei der Winkel gegenüber der Basis zwei Mal größer ist als der maximale Abweichungswinkel (amax).

7. Panel (312) nach einem der vorstehenden Ansprüche, **dadurch gekennzeichnet:**
- **dass** die Struktur (14) eine längliche Form gemäß einer Längsachse (Y) senkrecht zu einer Querachse (X) aufweist; und
- **dass** das Gitter jeder Zelle (316A, 316B) eine Vielzahl von Leitungsdrähten umfasst, die sich gemäß der Längsachse (Y) erstrecken.

8. Panel (312) nach Anspruch 7, **dadurch gekennzeichnet, dass** sich das Gitter jeder Zelle (316A, 316B) in Form eines Kamms darstellt, dessen Zähne von den Leitungsdrähten gebildet werden, die sich gemäß der Längsachse (Y) erstrecken.

9. Panel (312) nach Anspruch 7 oder 8, **dadurch gekennzeichnet:**
- **dass** es sich an Bord in einem Raumfahrzeug (10) befindet, das gemäß einer Umlaufbahn (O1) dreht; und
- **dass** die Längsachse (Y) senkrecht auf die Ebene verläuft, welche die Umlaufbahn (O1) umfasst.

10. Panel (12; 112; 212; 312) nach einem der Ansprüche 1 bis 9, **dadurch gekennzeichnet, dass** die Schranke (18A; 118A; 218A; 318A) aus einem flexiblen Material hergestellt ist, wobei die Schranke (18A; 118A; 218A; 318A) angepasst ist, um in dem Raum, der von den zwei seitlichen Kontaktflächen (30A, 30B) gebildet wird, gefaltet zu werden, ohne in Bezug auf die Paneloberfläche (19) vorzuspringen.

11. Panel (12; 112; 212; 312) nach einem der Ansprüche 1 bis 10, **dadurch gekennzeichnet, dass** die Schranke (18A; 118A; 218A; 318A) aus einem Polyimid-Polymer hergestellt ist.

12. Panel (212) nach einem der Ansprüche 1 bis 11, **dadurch gekennzeichnet, dass** die Schranke (218A) ein Konzentrator ist.

## Claims

1. A solar panel (12; 112; 212; 312) including:
- a structure (14) in contact with an ambient environment;
- at least two photovoltaic cells (16A, 16B; 316A, 316B), each cell (16A, 16B; 316A, 316B) defining a lateral contact face (30A, 30B) and including a base element (20A, 20B), an electrical conductor grid (24A, 24B) and a protective element (22A, 22B) made of transparent material, the grid (24A, 24B) being disposed between the protective element (22A, 22B) and the base element (20A, 20B) and including at least one conductive wire housing the lateral contact face (30A, 30B) of the cell (16A, 16B; 316A, 316B);
the two cells (16A, 16B; 316A, 316B) being disposed on the structure (14) such that at least one portion of each of the lateral contact faces (30A, 30B) is disposed opposite to the other portion and such that the protective elements (22A, 22B) of these cells (16A, 16B; 316A, 316B) form a panel surface (19);
the cells (16A, 16B; 316A, 316B) being disposed such that the shortest path passing through the ambient environment between the portions opposite to the lateral contact faces (30A, 30B) of the two cells (16A, 16B; 316A, 316B) is equal to at least about 20 mm,
the solar panel (12; 112; 212; 312) being **characterized in that** it further includes a barrier (18A; 118A; 218A; 318A) made of dielectric material which is disposed on the structure (14) between the lateral contact faces (30A, 30B) of the two photovoltaic cells (16A, 16B; 316A, 316B), extending along the portions opposite to these faces (30A, 30B) and protruding from the panel surface (19), the shortest path between the portions opposite to the lateral contact faces (30A, 30B) being calculated by bypassing the barrier (18A; 118A; 218A; 318A), the barrier (18A; 118A; 218A; 318A) being disposed between each couple of photovoltaic cells (16A, 16B; 316A, 316B) between which the voltage is greater than 30V.

2. The panel (12; 112; 212; 312) according to claim 1, **characterized:**
- **in that** it is designed to operate in an environment in which the direction (P) perpendicular to the panel surface (19) deviates from a lighting direction (E) by a maximum spread angle (amax) less than 90°, the lighting direction (E) being defined by a straight line passing through the center of a lighting source (S) and a predetermined point of the panel; and
- **in that** the barrier (18A; 118A; 218A; 318A) and/or the cells (16A, 16B) are disposed such that the shadow generated by the barrier (18A; 118A; 218A; 318A), when the direction (P) perpendicular to the panel surface (19) deviates from the lighting direction (E) by the maximum spread angle (αmax), is substantially outside each of the two cells (16A, 16B; 316A, 316B).

3. The panel (12; 112; 212; 312) according to claim 1 or 2, **characterized in that** it is on board a spacecraft (10).

4. The panel (12; 112; 212; 312) according to any one of claims 1 to 3, **characterized in that** the barrier (18A; 118A; 218A; 318A) protrudes from the panel surface (19) of at least about 10 mm.

5. The panel (12; 112; 212) according to any one of claims 1 to 4, **characterized in that** the portions opposite to the two cells are spaced apart by at least about 9 mm.

6. The panel (12; 112; 212; 312) according to any one of claims 2 to 5, **characterized in that** the cross section of the barrier (118A; 218A; 318A) forms an isosceles triangle whose base is adjacent to the structure (14), the angle opposite to the base being twice the maximum spread angle (amax).

7. The panel (312) according to any one of the preceding claims, **characterized:**
- **in that** the structure (14) has an elongated shape along a longitudinal axis (Y) perpendicular to a transverse axis (X); and
- **in that** the grid of each cell (316A, 316B) includes a plurality of conductive wires extending along the longitudinal axis (Y).

8. The panel (312) according to claim 7, **characterized in that** the grid of each cell (316A, 316B) is in the form of a comb whose teeth are formed of conductive wires extending along the longitudinal axis (Y).

9. The panel (312) according to claim 7 or 8, **characterized:**
- **in that** it is on board a spacecraft (10) rotating along an orbit (O1) ; and
- **in that** the longitudinal axis (Y) is perpendicular to the plane comprising the orbit (O1).

10. The panel (12; 112; 212; 312) according to any one of claims 1 to 9, **characterized in that** the barrier (18A; 118A; 218A; 318A) is made of a flexible material, the barrier (18A; 118A; 218A; 318A) being adapted to be folded in the space delimited by the two lateral contact faces (30A, 30B) without protruding from the panel surface (19).

11. The panel (12; 112; 212; 312) according to any one of claims 1 to 10, **characterized in that** the barrier (18A; 118A; 218A; 318A) is made of a polyimide polymer.

12. The panel (212) according to any one of claims 1 to 11, **characterized in that** the barrier (218A) is a concentrator.
